# EUROPEAN PATENT APPLICATION

(11) **EP 4 733 706 A1**
(43) Date of publication of application: **29.04.2026**
(21) Application number: 23942402.1
(22) Date of filing: 22.06.2023
(51) Int. Cl.: F28F 21/06, B32B 5/00, B32B 5/12, B64G 1/50, F28F 3/00, F28F 13/00, G05D 23/02, G12B 15/06, H05K 7/20

(54) **HEAT DISSIPATION MEMBER AND METHOD FOR MANUFACTURING HEAT DISSIPATION MEMBER**

(71) Applicant: MITSUBISHI ELECTRIC CORPORATION, Chiyoda-ku Tokyo 100-8310 (JP)
(72) Inventor: KOYAMA, Tatsuya, Tokyo 100-8310 (JP); TAKAGAKI, Kazunori, Tokyo 100-8310 (JP); TAKAHASHI, Ichiya, Tokyo 100-8310 (JP)
(74) Representative: Meissner Bolte Partnerschaft mbB
(86) International application number: PCT/JP2023/023151
(87) International publication number: WO 2024/261969

(57) **Abstract**

A heat dissipation member (100) includes a laminated body (100L) including a plurality of composite material layers having fiber orientations. The laminated body (100L) has a roll shape obtained by rolling up a plate-like body, includes at least two composite material layers having different fiber orientations, and has an arrangement of the fiber orientations of the plurality of composite material layers, the fiber orientations being arranged asymmetrically in a laminating direction. The laminated body (100L) autonomously changes its shape from the roll shape along with thermal expansion and thermal contraction occurring in a temperature change of the inside of the heat dissipation member (100). The laminated body (100L) in the roll shape extends in a -Y direction from the roll shape, as one change in the shape thereof.

## Description

### Technical Field

The present invention relates to a heat dissipation member and a method for manufacturing a heat dissipation member.

### Background Art

Satellites are in a vacuum environment in orbit and therefore, the satellites perform thermal control by radiation. In a satellite, heat inputted mainly from the sun and heat generated by onboard equipment balance with heat dissipation by radiation from the satellite to the outside. Thermal control is often designed based on the time of exposure to sunlight from the sun. The amount of heat dissipation increases in a shade and therefore, the temperature of onboard equipment is controlled by heater heating.

With regard to the heater heating, there is a need to suppress power consumption of the heater heating and increase an amount of power allocated to onboard equipment of a satellite to improve the satellite's functionality. Therefore, there is a demand for technology to control an amount of heat dissipation in accordance with a situation of heat input from the sun.

For example, the thermal louver in Patent Literature 1 is driven using a bimetal which bends in accordance with temperature changes. The thermal louver of Patent Literature 1 performs thermal control in a manner such that heat is dissipated by putting out a heat dissipation surface when the temperature is high and a heat insulation surface is put out when the temperature is low. However, the thermal louver in Patent Literature 1 has problems in that the mechanism thereof is complicated and the weight thereof is heavy due to the use of bimetal.

### Citation List

### Patent Literature

Patent Literature 1: JP S58-221 416 A

### Summary of the Invention

### Technical Problem

An object of the present invention is to provide a heat dissipation member which has a simple mechanism and light weight.

### Solution to Problem

A heat dissipation member according to the present invention includes: a laminated body including a plurality of composite material layers having fiber orientations.

The laminated body
has a roll shape obtained by rolling up a plate-like body,
includes at least two composite material layers having different fiber orientations,
has an arrangement of the fiber orientations of the plurality of composite material layers, the fiber orientations being arranged asymmetrically in a laminating direction, and
autonomously changes a shape thereof from the roll shape along with thermal expansion and thermal contraction occurring in a temperature change.

### Advantageous Effects of Invention

The heat dissipation member of the present invention includes a laminated body including a plurality of composite material layers, and autonomously changes a shape thereof from a roll shape along with thermal expansion and thermal contraction occurring in a temperature change of the heat dissipation member. Therefore, according to the heat dissipation member of the present invention, it is possible to provide a heat dissipation member which controls the amount of heat dissipation depending on sun and shade and has a light weight.

### Brief Description of Drawings

FIG. 1 is a diagram of Embodiment 1 which is a schematic view of a shape of a heat dissipation member 100 at low temperature.
FIG. 2 is a diagram of Embodiment 1 which is a schematic view of a shape of the heat dissipation member 100 at high temperature.
FIG. 3 is a diagram of Embodiment 1 which schematically illustrates an A-A section of the heat dissipation member 100.
FIG. 4 is a diagram of Embodiment 1 which illustrates a difference in emissivity in a surface of the heat dissipation member 100.
FIG. 5 is a diagram of Embodiment 1 which illustrates an overview of a method for manufacturing the heat dissipation member 100.
FIG. 6 is a diagram of Embodiment 2 which is a schematic view of the heat dissipation member 100 of Embodiment 2 at high temperature.
FIG. 7 is a diagram of Embodiment 2 which schematically illustrates a B-B section of the heat dissipation member 100.

### Description of Embodiments

In description and drawings of embodiments, the same and corresponding components are given the same reference characters. Description of components having the same reference characters will be omitted or simplified as appropriate.

### Embodiment 1.

### Description of configuration

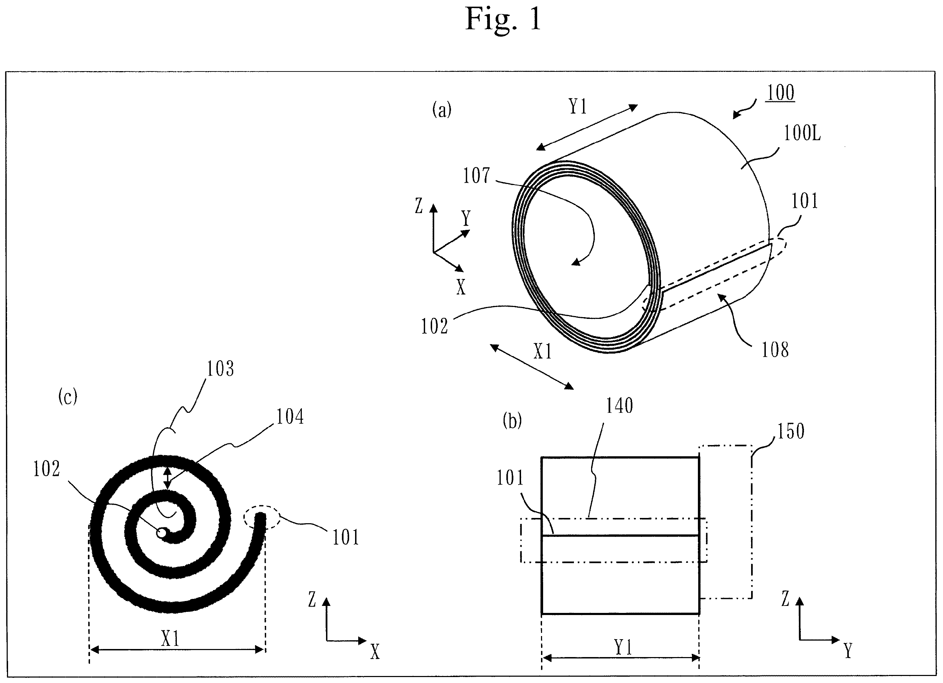

A heat dissipation member 100 of Embodiment 1 will be described with reference to FIGS. 1 to 5.

FIG. 1 is a schematic view of a shape of the heat dissipation member 100 at low temperature. (a) of FIG. 1 is a perspective view of the heat dissipation member 100. (a) of FIG. 1 illustrates XYZ coordinates. (b) of FIG. 1 illustrates a YZ plane of the heat dissipation member 100. (c) of FIG. 1 illustrates a ZX plane of the heat dissipation member 100. (c) of FIG. 1 schematically illustrates a spiral shape of the heat dissipation member 100.

The heat dissipation member 100 includes a laminated body 100L including a plurality of composite material layers having fiber orientations. The laminated body 100L has a roll shape obtained by rolling up a plate-like body, as illustrated in (a) of FIG. 1. The laminated body 100L includes at least two composite material layers having different fiber orientations. The laminated body 100L has an arrangement of the fiber orientations of a plurality of composite material layers, where the fiber orientations are arranged asymmetrically in a laminating direction.

### Thermal deformation of laminated body 100L

The laminated body 100L autonomously changes its shape from the roll shape along with thermal expansion and thermal contraction occurring in a temperature change of the laminated body 100L. The change in the shape of the laminated body 100L is at least one of a change of extending in a plate-width direction of a plate-like body from the roll shape and a change of unwinding of the roll shape.

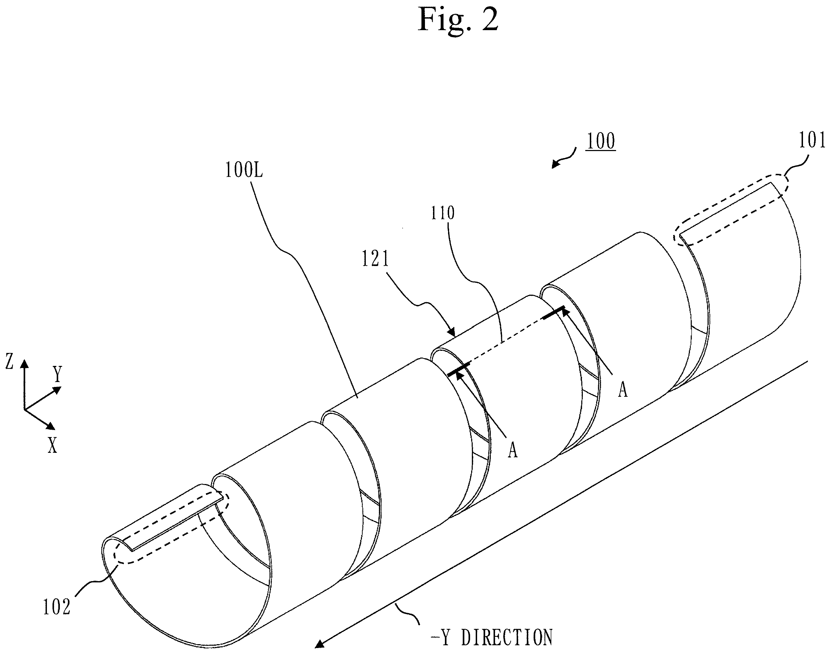

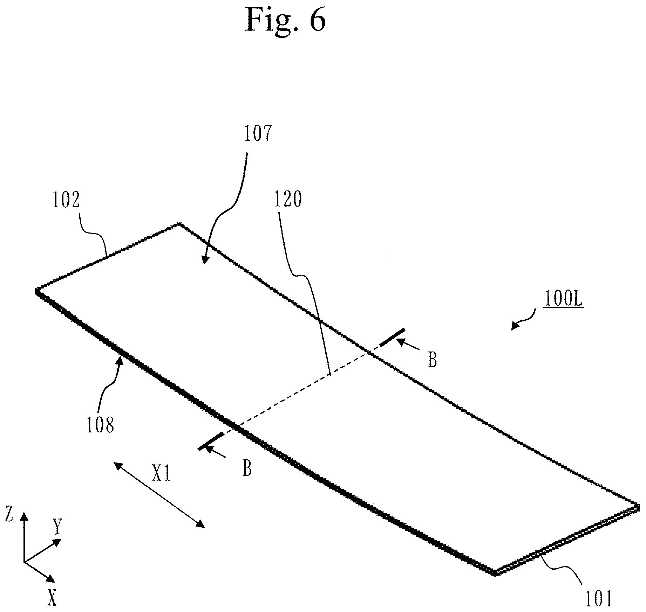

The plate width of the plate-like body is Y1 shown in (a) of FIG. 1, and the plate-width direction is a +Y direction or a -Y direction shown in (a) of FIG. 1. The change of extending in the plate-width direction of the plate-like body from the roll shape will be described later with reference to FIG. 2. The change of unwinding of the roll shape will be described later with reference to FIG. 6 in Embodiment 2.

An outer circumferential end portion 101 of the heat dissipation member 100 is attached to a fixture 140 fixed to a satellite, whereby the heat dissipation member 100 is mounted on the satellite. The fixture 140 is illustrated in (b) of FIG. 1 by a double-dashed line. Here, the fixture 140 may be attached to an inner circumferential end portion 102 of the heat dissipation member 100.

### Roll shape

The heat dissipation member 100 has a rolled spiral shape as illustrated in (a) of FIG. 1. There is a gap 104 between layers in the roll shape as shown as a range 103. This is because no friction occurs between the layers. Here, the layers in the roll shape are different from layers in a laminated body described later. The layers in the roll shape are layers formed when the plate-like body is wound into a roll, and the layers in the laminated body are respective layers in a lamination structure of the plate-like body.

### <Shape at high temperature>

FIG. 2 illustrates a schematic view of a shape of the heat dissipation member 100 at high temperature. FIG. 2 illustrates a state in which the heat dissipation member 100 deforms in the -Y direction (plate-width direction) when the temperature of the heat dissipation member 100 changes from the temperature in FIG. 1 to a higher temperature.

The change in the shape of the laminated body 100L in FIG. 2 is a change of extending in the plate-width direction (-Y direction) from the roll shape.

The temperature of the heat dissipation member 100 rises due to heat transfer from a satellite to the heat dissipation member 100 and absorption of sunlight and albedo radiation. Albedo radiation is radiation of sunlight reflected off the earth and the moon and directed to a satellite. The temperature rise of the heat dissipation member 100 causes thermal deformation of the heat dissipation member 100. When the outer circumferential end portion 101 is fixed to a fixture, the heat dissipation member 100 thermally deforms from the roll shape of FIG. 1 to extend in the -Y direction of FIG. 2.

The extension in the -Y direction greatly increases an area of the heat dissipation member 100 for radiation toward space. The increased area of the heat dissipation member 100 for radiation toward space greatly increases radiation from the heat dissipation member 100, facilitating heat exhaustion of the satellite.

### Decrease in temperature

When the heat generation of the satellite decreases and heat transport decreases, the temperature of the heat dissipation member 100 decreases. The decrease in temperature of the heat dissipation member 100 generates thermal deformation of the heat dissipation member 100 and eventually, the heat dissipation member 100 autonomously returns to be in the roll shape of FIG. 1 even without any external force acting thereon.

### Fiber orientation of laminated body

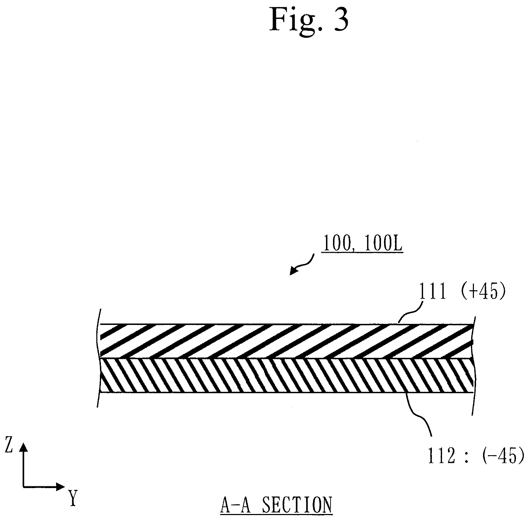

FIG. 3 schematically illustrates an A-A section of a cut point 110 (FIG. 2) of the heat dissipation member 100. The A-A section is the laminated body 100L including two layers having fiber orientations.

As illustrated in FIG. 3, the laminated body 100L includes two composite material layers. One composite material layer has the fiber orientation of +45°, and the other composite material layer has the fiber orientation of -45°. Both an upper layer 111 and a lower layer 112 are a UD (Uni-directional) material of carbon fiber reinforced plastic. The upper layer 111 is on a surface layer side of the roll shape, and the lower layer 112 is on an inner layer side of the roll shape. The fiber orientation of the upper layer 111 is +45° and the fiber orientation of the lower layer 112 is -45°.

A laminated body of carbon fiber reinforced plastic generally has symmetrical fiber orientations in the thickness direction. Namely, in a two-layer laminated body as that in FIG. 3, when the upper layer 111 has the fiber orientation of +45°, the lower layer 112 also has the fiber orientation of +45° in general.

On the other hand, in the heat dissipation member 100, the fiber orientations are asymmetrical in the thickness direction. Namely, in the heat dissipation member 100, it is +45° in the upper layer 111, while it is -45° in the lower layer 112, as illustrated in FIG. 3. The fiber orientations of the upper layer 111 and the lower layer 112 are thus asymmetrical in the thickness direction (Z direction).

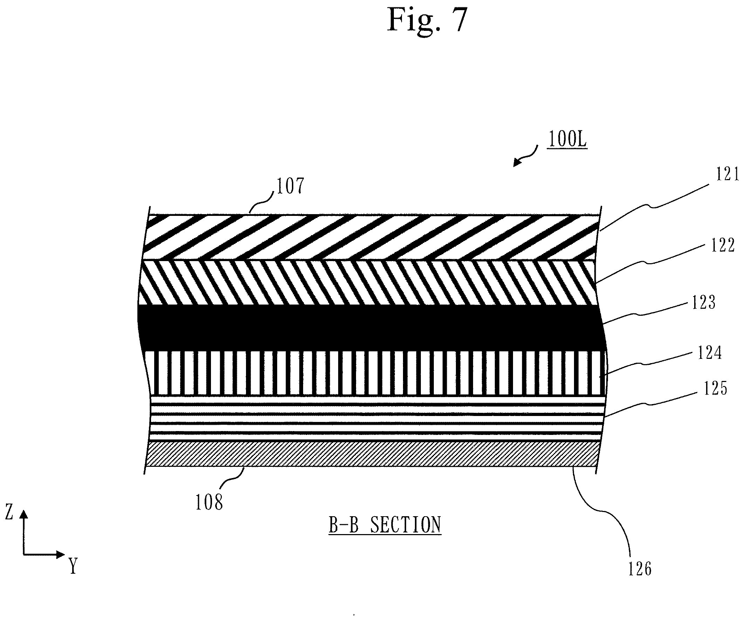

In FIG. 7 described later, the lamination arrangement of fiber orientations from the surface layer side of the roll shape to the inner layer side is: an upper surface layer 121, an upper inner layer 122, a lower inner layer 124, and a lower surface layer 125, in this order. The upper surface layer 121 is glass fiber reinforced plastic with a fiber orientation of 90°, in FIG. 7. The upper inner layer 122 is carbon fiber reinforced plastic with a fiber orientation of 90°. The lower inner layer 124 is carbon fiber reinforced plastic with a fiber orientation of 0°. The lower surface layer 125 is glass fiber reinforced plastic with a fiber orientation of 0°.

When considering the symmetric property of fiber orientations in the thickness direction, a central layer 123 between the upper inner layer 122 and the lower inner layer 124 corresponds to an axis of symmetry in the laminating direction (Z direction). With respect to the central layer 123, there are two fiber orientations of 90° on the upper side and two fiber orientations of 0° on the lower side.

Thus, the laminated body 100L in FIG. 7 includes at least two composite material layers having different fiber orientations, and has a fiber orientation arrangement of a plurality of composite material layers (the upper surface layer 121, the upper inner layer 122, the lower inner layer 124, the lower surface layer 125) arranged asymmetrically in the laminating direction (Z direction).

### Fiber orientation and material property

Combined orientation control of fiber orientations and material properties enables thermal deformation centering on torsional deformation. The heat dissipation member 100 autonomously changes a radiation area in accordance with a change in temperature of the heat dissipation member 100 by thermal deformation centering on torsional deformation.

### Composite material

The upper layer 111 and the lower layer 112 illustrated in FIG. 3 are both assumed to employ carbon fiber reinforced plastic as a composite material.
(1) However, the composite material is not limited to carbon fiber reinforced plastic. Not limited to carbon fiber reinforced plastic, the upper layer 111 and the lower layer 112 can employ fibers different from carbon fiber, such as glass fiber reinforced plastic and aramid fiber reinforced plastic.
(2) The upper layer 111 and the lower layer 112 may be a combination of different types of fibers.
(3) A UD material of carbon fiber reinforced plastic is assumed to be used for the heat dissipation member 100, but discontinuous fibers may be used to provide fiber orientations in the heat dissipation member 100.
(4) The matrix of the composite material may be thermosetting resin, thermoplastic resin, or metal.

### Emissivity control

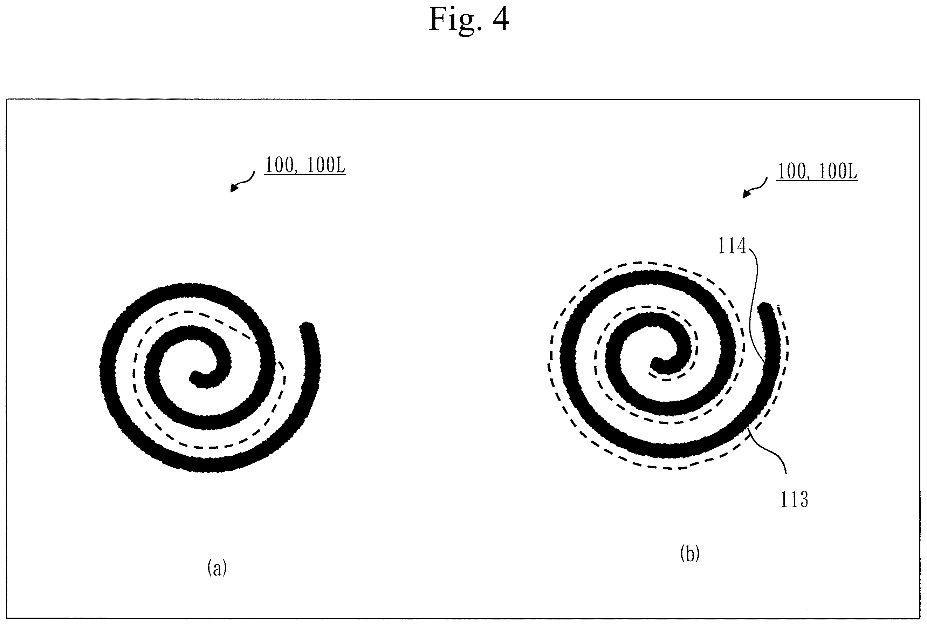

FIG. 4 illustrates a difference in emissivity in a surface of the heat dissipation member 100. The surface of the heat dissipation member 100 may be coated to suppress radiation. The coating on the outermost layer surface in the low temperature state in FIG. 1 is preferably a material which reflects radiation from outside such as the albedo from the earth or the moon and has low emissivity for suppressing radiation from the heat dissipation member 100, for example, a metal such as aluminum. On the other hand, when heat is desired to be actively dissipated by radiation, the surface exposed by thermal deformation is preferably a material with high emissivity, such as ceramic or black paint.

In (a) of FIG. 4, the laminated body 100L has a plurality of regions with different emissivity on the surface thereof. In (a) of FIG. 4, the emissivity of the region near the center of the spiral enclosed by a dotted line is higher, and the emissivity in the outside of the dotted line is lower than the range enclosed by the dotted line. A configuration may also be employed in which the emissivity of the region near the center of the spiral enclosed by the dotted line is lower and the emissivity in the outside of the dotted line is higher than the range enclosed by the dotted line.

In (b) of FIG. 4, the laminated body 100L has different emissivity between a front surface 113 in the laminating direction and a back surface 114 on the back side of the front surface 113. That is, in (b) of FIG. 4 illustrating a roll shape, the front surface 113 in the laminating direction is a surface closer to a dotted line. The back surface 114 is a surface on the back side of the dotted line. The emissivity of the front surface 113 is higher and the emissivity of the back surface 114 is lower than that of the front surface 113 in (b) of FIG. 4. However, a configuration may also be employed in which the emissivity of the front surface 113 is lower and the emissivity of the back surface 114 is higher than that of the front surface 113.

### Method for manufacturing heat dissipation member 100

The heat dissipation member 100 is manufactured taking into account a temperature at which the shape in FIG. 1 is obtained, a temperature during manufacturing, and an amount of deformation assumed from a layer structure of the laminated body. Namely, the heat dissipation member 100 at the point in FIG. 1 is assumed to be 0 °C. The molding temperature of carbon fiber reinforced plastic is 130 °C and therefore, molding is performed for a shape corresponding to an amount of deformation equivalent to 130° of temperature difference.

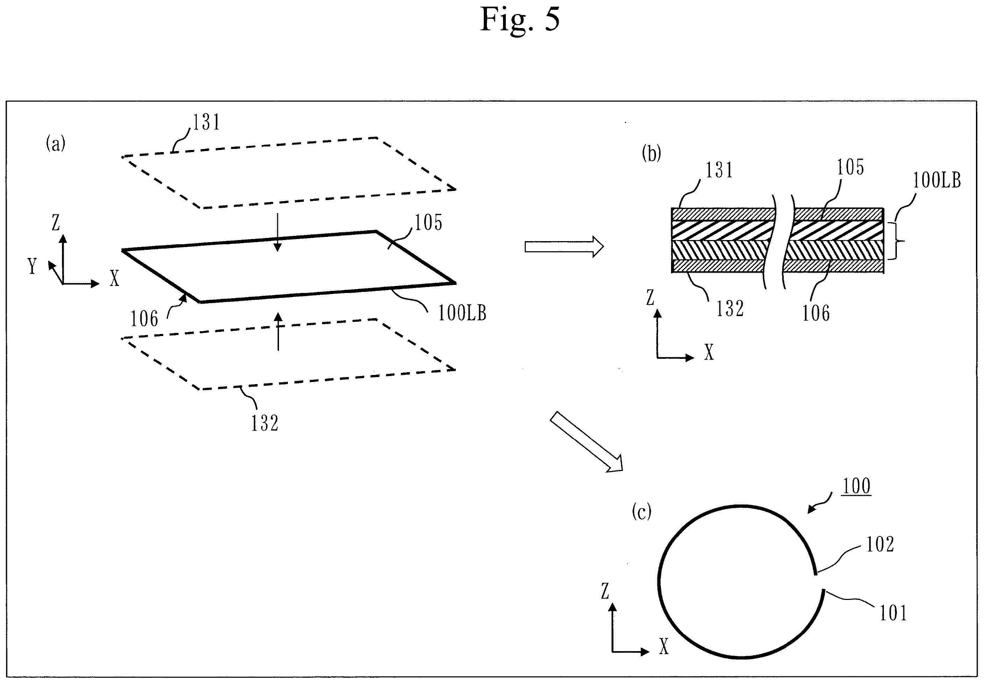

FIG. 5 illustrates an overview of a method for manufacturing the heat dissipation member 100. (a) of FIG. 5 illustrates a process of covering one surface 105 in the laminating direction (Z direction) of a plurality of composite materials 100LB and the other surface 106 in the opposite direction (-Z direction) with an adhesion prevention member.

(b) of FIG. 5 illustrates a state in which the one surface 105 and the other surface 106 of the plurality of composite materials 100LB are covered with mold release films 131 and 132 respectively which are the adhesion prevention member. (c) of FIG. 5 illustrates a state in which the heat dissipation member 100 has no overlapping layers of a spiral when the heat dissipation member 100 is molded in a roll shape.

The method for manufacturing the heat dissipation member 100 includes the following processes (1) and (2).
(1) A process to cover one surface 105 in one laminating direction (+Z direction) of a plurality of composite materials which are laminated and the other surface 106 in the opposite direction (-Z direction) to the one laminating direction with an adhesion prevention member for preventing adhesion between the one surface 105 and the other surface 106 when the plurality of composite materials having fiber orientations are laminated.
(2) A process to mold the plurality of composite materials into a roll shape by winding the plurality of composite materials, the one surface 105 and the other surface 106 of which are covered with the adhesion prevention member, around a molding die.

The plurality of composite materials 100LB are a plurality of composite materials which are arranged in layers and are before becoming the laminated body 100L having the roll shape. As illustrated in (b) of FIG. 5, the upper side of the plurality of composite materials 100LB is covered with the mold release film 131 and the lower side is covered with the mold release film 132.

The mold release films 131 and 132 are an example of the adhesion prevention member. The plurality of composite materials 100LB are sandwiched by the mold release films in molding into the roll shape. Accordingly, even when the heat dissipation member 100 has overlapping spiral layers illustrated in (c) of FIG. 1, the one surface 105 and the other surface 106 do not adhere to each other during molding. The heat dissipation member 100 having the roll shape is thus obtained in which there is no adhesion between the one surface 105 and the other surface 106.

The adhesion prevention member is not limited to the mold release film as long as the adhesion prevention member can be peeled off from the one surface 105 and the other surface 106 without any damage after molding the heat dissipation member 100. Here, the use of mold release films 131 and 132 is unnecessary if the roll shape without overlapping layers of a spiral as that illustrated in (c) of FIG. 5 is formed.

In molding of a roll shape having overlapping layers of a spiral, a molding die is preferably tapered cone-shaped so that the gap 104 is created between the layers of the spiral at the time of molding. A prepreg in which fibers are aligned in one direction and have been impregnated with resin is preferably used as a molding material, and autoclave molding is preferably employed as a molding method. A plurality of layers of carbon fiber reinforced plastic may be laminated and the heat dissipation member 100 may be molded by RTM (Resin Transfer Molding). Pultrusion molding may be used for RTM. RTM is a molding method in which molding is performed with impregnation of resin.

When continuous fibers are not used, injection molding, BMC (Bulk Mold Compound), or SMC (Sheet Mold Compound) may be employed to mold the heat dissipation member 100.

### Stopper

If the temperature of the heat dissipation member 100 unintentionally becomes lower than the temperature (0 °C) of the shape in FIG. 1, the heat dissipation member 100 extends in the +Y direction from the roll shape of (a) of FIG. 1, increasing a heat dissipation area.

Namely, the laminated body 100L extends in one direction (-Y direction) in the plate-width direction and the opposite direction (+Y direction) to the one direction, and at the same time, the heat dissipation member 100 further includes a stopper for suppressing the extension of the laminated body 100L in the opposite direction. Thus, the heat dissipation member 100 is preferably provided with a stopper 150 (FIG. 1) for restraining the heat dissipation member 100 from extending in the opposite direction (+Y direction).

The fixture 140 (FIG. 1) connecting the heat dissipation member 100 and a satellite preferably has high thermal conductivity. For example, a graphite sheet with high thermal conductivity may be used for the fixture 140. Further, part of the material of the fixture 140 may be molded simultaneously with the heat dissipation member 100 to be integrated with the heat dissipation member 100.

### Advantageous effect of Embodiment 1

(1) The heat dissipation member 100 includes the laminated body including a plurality of composite material layers. The laminated body 100L autonomously changes its shape from a roll shape along with thermal expansion and thermal contraction occurring in a temperature change of the heat dissipation member 100. Therefore, according to the heat dissipation member 100, it is possible to provide a heat dissipation member which can control the amount of heat dissipation depending on sun and shade and has a light weight.
(2) The heat dissipation member 100 includes the stopper 150 illustrated in FIG. 1, thereby being able to suppress thermal deformation based on an unintentional temperature drop.
(3) In the heat dissipation member 100, the emissivity varies on the surface of the laminated body 100L as described with reference to FIG. 4 and accordingly, heat dissipation can be precisely controlled.
(4) In the method for manufacturing the heat dissipation member 100, one surface 105 and the other surface 106 are covered with the adhesion prevention member as illustrated in FIG. 5, thereby being able to prevent adhesion between the one surface 105 and the other surface 106 during molding of the roll shape.

### Embodiment 2.

The heat dissipation member 100 of Embodiment 2 will be described below with reference to FIGS. 6 and 7. The heat dissipation member 100 of Embodiment 2 will be described with respect to differences from the heat dissipation member 100 of Embodiment 1.

The heat dissipation member 100 of Embodiment 2 is characterized in that the direction of thermal deformation is a circumferential direction.

FIG. 6 schematically illustrates a state of the heat dissipation member 100 of Embodiment 2 at high temperature. The heat dissipation member 100 extends in an X1 direction from the roll shape of FIG. 1. This allows the heat dissipation member 100 to greatly increase an area for radiation toward space.

The change in the shape of the laminated body 100L is a change of unwinding of the roll shape. As illustrated in FIG. 6, the change of unwinding of the roll shape is a decrease in curvature in a roll circumferential direction in at least part of a region of the roll shape.

### Lamination structure

FIG. 7 illustrates a schematic view of a B-B section at a cut point 120 of the heat dissipation member 100. The laminated body 100L includes at least four composite material layers. From the inside to the outside of the roll shape, respective composite material layers are defined as a first composite material layer, a second composite material layer, a third composite material layer, and a fourth composite material layer. (a) of FIG. 1 and FIG. 6 illustrate a roll-shape inner surface 107 and a roll-shape outer surface 108.

The roll-shape inner surface 107 is positioned on the inner side of the roll shape and the roll-shape outer surface 108 is positioned on the outer side of the roll shape. In FIG. 6, the roll-shape outer surface 108 is a back surface of the roll-shape inner surface 107. In FIG. 6, from the roll-shape inner surface 107 to the roll-shape outer surface 108, respective composite material layers are defined as a first composite material layer, a second composite material layer, a third composite material layer, and a fourth composite material layer.

In the correspondence in FIG. 7, the first composite material layer is the upper surface layer 121. The second composite material layer is the upper inner layer 122. The third composite material layer is the lower inner layer 124. The fourth composite material layer is the lower surface layer 125.

In FIG. 7, the heat dissipation member 100 is composed of six layers: a five-layer laminated body and one coating layer. The upper side is defined as the +Z direction. The upper surface layer 121 is glass fiber reinforced plastic with a fiber orientation of 90°. The upper inner layer 122 is carbon fiber reinforced plastic with a fiber orientation of 90°. The central layer 123 is a graphite sheet with high thermal conductivity. The lower inner layer 124 is carbon fiber reinforced plastic with a fiber orientation of 0°. The lower surface layer 125 is glass fiber reinforced plastic with a fiber orientation of 0°. The lowermost side is a coating layer 126.

The laminated body 100L has, between composite material layers of the plurality of composite material layers, a high-thermal-conductivity layer having higher thermal conductivity than any composite material layer of the plurality of composite material layers. The central layer 123 which is described below is an example of implementation of the high-thermal-conductivity layer.

By providing the central layer 123 which is a layer having high thermal conductivity (high-thermal-conductivity layer), temperature distribution in the heat dissipation member 100 is reduced, thus being able to increase the efficiency of heat dissipation. The coating layer 126 is made of ceramic and binder. The ceramic increases the emissivity, and the binder suppresses cracking during deformation. Compared to carbon fiber reinforced plastic, glass fiber reinforced plastic exhibits large thermal expansion.

Therefore, greater deformation can be achieved by using glass fiber reinforced plastic. On the other hand, carbon fiber reinforced plastic exhibits higher thermal conductivity than glass fiber reinforced plastic. Accordingly, the use of carbon fiber reinforced plastic in combination with glass fiber reinforced plastic can achieve both high amounts of deformation and heat dissipation. The required amount of deformation of the heat dissipation member 100 varies depending on a relationship between an expected temperature range and a required heat dissipation area. When large deformation is required with a small temperature change, it is preferable to use a plurality of types of materials in combination.

### Advantageous effect of Embodiment 2

In the heat dissipation member 100, the change in the shape of the laminated body 100L is the change of unwinding of the roll shape. Therefore, the heat dissipation area can be secured compared to the heat dissipation member 100 of Embodiment 1.

The heat dissipation member 100 has the lamination structure illustrated in FIG. 7, thereby achieving the change of unwinding of the roll shape in the -Y direction.

Further, the central layer 123 is a graphite sheet with high thermal conductivity in the configuration illustrated in FIG. 7 and therefore, the heat dissipation member 100 can efficiently dissipate heat.

In addition, in the configuration illustrated in FIG. 7, the coating layer 126 is on the lowermost side and accordingly, thermal deformation and heat dissipation can be balanced.

### List of Reference Signs

- 100:: heat dissipation member
- 100L:: laminated body
- 100LB:: a plurality of composite materials
- 101:: outer circumferential end portion

- 102:: inner circumferential end portion
- 103:: range
- 104:: gap
- 105:: one surface
- 106:: the other surface
- 107:: roll-shape inner surface
- 108:: roll-shape outer surface
- 110:: cut point
- 111:: upper layer
- 112:: lower layer
- 113:: front surface
- 114:: back surface
- 120:: cut point
- 121:: upper surface layer
- 122:: upper inner layer
- 123:: central layer
- 124:: lower inner layer
- 125:: lower surface layer
- 131,132:: mold release film
- 140:: fixture
- 150:: stopper.

## Claims

1. A heat dissipation member comprising:
a laminated body including a plurality of composite material layers having fiber orientations, wherein
the laminated body
has a roll shape obtained by rolling up a plate-like body,
includes at least two composite material layers having different fiber orientations,
has an arrangement of the fiber orientations of the plurality of composite material layers, the fiber orientations being arranged asymmetrically in a laminating direction, and
autonomously changes a shape thereof from the roll shape along with thermal expansion and thermal contraction occurring in a temperature change.

2. The heat dissipation member according to claim 1, wherein
the change in the shape of the laminated body is at least one of a change of extending in a plate-width direction of the plate-like body from the roll shape and a change of unwinding of the roll shape.

3. The heat dissipation member according to claim 2, wherein
the change of unwinding of the roll shape is a decrease in curvature in a roll circumferential direction in at least part of a region of the roll shape.

4. The heat dissipation member according to any one of claims 1 to 3, wherein
the laminated body has a plurality of regions with different emissivity on a surface thereof.

5. The heat dissipation member according to any one of claims 1 to 4, wherein
the laminated body has different emissivity between a front surface in the laminating direction and a back surface on a back side of the front surface in the laminating direction.

6. The heat dissipation member according to any one of claims 1 to 5, wherein
the laminated body has a high-thermal-conductivity layer between composite material layers of the plurality of composite material layers, the high-thermal-conductivity layer having higher thermal conductivity than any composite material layer of the plurality of composite material layers.

7. The heat dissipation member according to claim 1, wherein
the change in the shape of the laminated body is a change of extending in the plate-width direction from the roll shape.

8. The heat dissipation member according to claim 7, wherein
the laminated body includes two layers of the composite material layers,
one of the composite material layers has a fiber orientation of +45°, and
the other of the composite material layers has a fiber orientation of -45°.

9. The heat dissipation member according to claim 7 or 8, wherein
the laminated body extends in one direction in the plate-width direction and an opposite direction to the one direction, and
the heat dissipation member further includes a stopper to suppress extension of the laminated body in the opposite direction.

10. The heat dissipation member according to claim 1, wherein
the change in the shape of the laminated body is a change of unwinding of the roll shape.

11. The heat dissipation member according to claim 10, wherein
the laminated body includes at least four layers of the composite material layers, and
when respective composite material layers are defined as a first composite material layer, a second composite material layer, a third composite material layer, and a fourth composite material layer from an inside to an outside of the roll shape,
the first composite material layer is glass fiber reinforced plastic with a fiber orientation of +90°,
the second composite material layer is carbon fiber reinforced plastic with a fiber orientation of +90°,
the third composite material layer is carbon fiber reinforced plastic with a fiber orientation of 0°, and
the fourth composite material layer is glass fiber reinforced plastic with a fiber orientation of 0°.

12. A method for manufacturing a heat dissipation member,
the method comprising:
covering one surface in one laminating direction of a plurality of composite materials, in which the plurality of composite materials having fiber orientations are laminated, and the other surface in the other laminating direction, the other laminating direction being an opposite direction to the one laminating direction, with an adhesion prevention member to prevent adhesion between the one surface and the other surface; and
molding the plurality of composite materials into a roll shape by winding the plurality of composite materials, the one surface and the other surface of which are covered with the adhesion prevention member, around a molding die.
